(19) Europäisches Patentamt
European Patent Office
Office européen des brevets

(11) EP 3 944 280 A1

(12) DEMANDE DE BREVET EUROPEEN

(43) Date de publication:
**26.01.2022 Bulletin 2022/04**

(21) Numéro de dépôt: **21186426.9**

(22) Date de dépôt: **19.07.2021**

(51) Classification Internationale des Brevets (IPC):
***H01H 47/00*** *(2006.01)* ***H01H 47/32*** *(2006.01)*

(52) Classification Coopérative des Brevets (CPC):
**H01H 47/002; H01H 47/32;** H01H 2047/008; H01H 2047/009

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **20.07.2020 FR 2007593**

(71) Demandeur: **Schneider Electric Industries SAS
92500 Rueil-Malmaison (FR)**

(72) Inventeurs:
- **DELBAERE, Stéphane
38240 MEYLAN (FR)**
- **ORBAN, Rémy
38410 SAINT MARTIN D'URIAGES (FR)**
- **GUIBERT, Philippe
38450 VIF (FR)**
- **JARRIGE, Christian
38960 SAINT AUPRE (FR)**

(74) Mandataire: **Lavoix
62, rue de Bonnel
69448 Lyon Cedex 03 (FR)**

(54) **PROCÉDÉS POUR ESTIMER UNE PROPRIÉTÉ D'UN APPAREIL DE COMMUTATION ÉLECTRIQUE, DISPOSITIFS ASSOCIÉS**

(57) Un procédé pour estimer une propriété d'un appareil de commutation électrique comporte des étapes consistant à :
- mesurer (102) le courant électrique circulant dans la bobine ;
- mesurer (104) la tension électrique d'alimentation d'un circuit de commande de l'actionneur ;
- injecter (106) une impulsion de courant électrique dans la bobine ;
- identifier (108) un premier instant correspondant à l'instant pour lequel le courant circulant dans la bobine atteint une valeur seuil prédéterminée lorsque ledit courant augmente suite à l'injection de l'impulsion ;
- identifier (110) un deuxième instant correspondant à l'instant pour lequel le courant circulant dans la bobine atteint à nouveau la valeur seuil prédéterminée lorsque ledit courant diminue après le pic ;
- estimer (112) la résistance de la bobine à partir du rapport entre la somme des valeurs de ladite tension mesurées entre le deuxième instant et le premier instant, et la somme des valeurs dudit courant mesurées entre le deuxième instant et le premier instant.

100
102
104
106
108
110
112
114
116

FIG.5

EP 3 944 280 A1

## Description

La présente invention se rapporte à des procédés pour estimer une propriété d'un appareil de commutation électrique, ainsi qu'à des dispositifs associés pour mettre en œuvre ces procédés.

L'invention concerne plus particulièrement les contacteurs électriques comportant un actionneur électromagnétique comprenant une bobine.

De tels appareils de commutation électrique sont configurés pour commuter entre un état ouvert et un état fermé, par exemple pour commander l'alimentation électrique d'une charge électrique. Généralement, des contacts électriques mobiles sont liés à une partie mobile de l'actionneur qui se déplace sous l'effet d'un champ magnétique créé par la bobine lorsque celle-ci est parcourue par un courant électrique adéquat.

Il est souhaitable de pouvoir estimer automatiquement une ou plusieurs propriétés de l'appareil lorsqu'il est en fonctionnement, par exemple dans le but de connaître son état et/ou de détecter l'apparition de dysfonctionnements et ainsi prévoir une maintenance préventive adaptée.

Certains appareils comportent des capteurs dédiés pour mesurer des propriétés de l'appareil telles que la température ou l'état d'usure des contacts électriques. Cependant, ces capteurs renchérissent le coût de fabrication de l'appareil. De plus, il n'est pas toujours possible d'intégrer un nouveau capteur à un appareil existant.

C'est à ces inconvénients qu'entend plus particulièrement remédier l'invention en proposant des procédés pour estimer une ou plusieurs propriétés d'un appareil de commutation électrique.

A cet effet, un aspect de l'invention concerne un procédé pour estimer une propriété d'un appareil de commutation électrique, ledit appareil comportant un actionneur électromagnétique comprenant une bobine, ce procédé comportant des étapes consistant à :

mesurer le courant électrique circulant dans la bobine :

mesurer la tension électrique d'alimentation d'un circuit de commande de l'actionneur ;
injecter une impulsion de courant dans la bobine de l'actionneur ;
identifier un premier instant correspondant à l'instant pour lequel le courant circulant dans la bobine atteint une valeur seuil prédéterminée lorsque ledit courant augmente suite à l'injection de l'impulsion ;
identifier un deuxième instant correspondant à l'instant pour lequel le courant circulant dans la bobine atteint à nouveau la valeur seuil prédéterminée lorsque ledit courant diminue après le pic de l'impulsion ;
estimer la résistance de la bobine à partir du rapport entre la somme des valeurs de ladite tension mesurées entre le deuxième instant et le premier instant, et la somme des valeurs dudit courant mesurées entre le deuxième instant et le premier instant.

Grâce à l'invention, il est possible de déterminer automatiquement et de façon fiable la valeur de la résistance de la bobine de l'actionneur pendant le fonctionnement de l'appareil, sans avoir besoin de capteur dédié.

Selon des aspects avantageux mais non obligatoires, un tel procédé peut incorporer une ou plusieurs des caractéristiques suivantes, prises isolément ou suivant toute combinaison techniquement admissible :

- Le procédé comporte en outre une étape d'estimation de l'inductance de la bobine de l'actionneur en fonction de la valeur de résistance estimée.
- L'inductance est calculée au moyen de la formule suivante :

$$L = \frac{Drl.Toff - (Rsh + RT1 + Rbob).\sum_{t+Ton}^{t+Ton+Toff} Icoil}{\left(Icoil_{Ton} - Icoil_{Toff}\right)}$$

  dans laquelle Rbob est la valeur de résistance estimée, $Icoil_{Ton}$ et $Icoil_{Toff}$ correspondent respectivement aux valeurs de courant mesurées au maximum de l'impulsion et à la fin de l'impulsion de courant, Toff correspond à la durée restante de l'impulsion de courant après l'atteinte du maximum de l'impulsion, Drl, Rsh et RT1 sont des constantes de construction propres à l'appareil et enregistrées en mémoire.
- Le procédé comporte en outre une étape d'estimation de la température de la bobine de l'actionneur en fonction de la valeur de résistance estimée.
- La température de la bobine est calculée de façon itérative au moyen de la formule suivante :

$$Temp_2 = \frac{\frac{Rbob_1}{Rbob_2} - 1}{K} + Temp_1$$

dans laquelle Temp2 est la valeur courante de la température de la bobine, Temp1 est la précédente estimation de la température, Rbob2 est la valeur courante de la résistance de la bobine, Rbob1 est une valeur précédente de la résistance de la bobine et K est le coefficient thermique du matériau formant la bobine.

- La résistance de la bobine est estimée au moyen de la formule suivante :

$$R = \frac{(R2\ + R1)/R1.\sum_t^{t+Ton} trs + \frac{Toff}{Ton + Toff}.Drl - RT4.\sum_t^{t+Ton} Icoil}{\sum_t^{t+Ton+Toff} Icoil} - (Rsh + RT1)$$

dans laquelle la somme $\sum_t^{t+Ton+Toff} Icoil$ correspond à la somme des valeurs de courant mesurés entre les premier et deuxième instants, « trs » correspond à la tension bobine mesurée, « t » correspond au premier instant précédemment défini, Ton correspond à la durée de l’impulsion de courant entre le premier instant t1 et l’atteinte d’une valeur maximale de l’impulsion de courant, Toff correspond à la durée restante de l’impulsion de courant après l’atteinte du maximum de courant et jusqu’au deuxième instant, Drl, Rsh, R1, R2, RT4 et RT1 sont des constantes de construction propres à l’appareil et enregistrées en mémoire.

- Le procédé est mis en œuvre lorsque l’appareil de commutation est dans l’état ouvert.
- Le procédé est mis en œuvre lorsque l’appareil de commutation est dans l’état fermé, de préférence pendant une phase de maintien dans laquelle l’impulsion de courant est répétée périodiquement.
- Le deuxième instant est identifié comme étant l’instant pour lequel la valeur du courant mesuré est la plus proche de la valeur seuil prédéterminée parmi les valeurs de courant mesurées lorsque ledit courant diminue après le pic de l’impulsion.

Selon un autre aspect, l’invention concerne un appareil de commutation électrique, comportant un actionneur électromagnétique comprenant une bobine et un circuit de commande configuré pour mettre en œuvre des étapes consistant à :

- mesurer le courant électrique circulant dans la bobine ;
- mesurer la tension électrique d’alimentation d’un circuit de commande de l’actionneur ;
- injecter une impulsion de courant électrique dans la bobine de l’actionneur;
- identifier un premier instant correspondant à l’instant pour lequel le courant circulant dans la bobine atteint une valeur seuil prédéterminée lorsque ledit courant augmente suite à l’injection de l’impulsion ;
- identifier un deuxième instant correspondant à l’instant pour lequel le courant circulant dans la bobine atteint à nouveau la valeur seuil prédéterminée lorsque ledit courant diminue après le pic de l’impulsion ;
- estimer la résistance de la bobine à partir du rapport entre la somme des valeurs de ladite tension mesurées entre le deuxième instant et le premier instant, et la somme des valeurs dudit courant mesurées entre le deuxième instant et le premier instant.

L’invention sera mieux comprise et d’autres avantages de celle-ci apparaîtront plus clairement à la lumière de la description qui va suivre d’un mode de réalisation d’un procédé donnée uniquement à titre d’exemple et faite en référence aux dessins annexés, dans lesquels :

[Fig 1] la figure 1 est une vue schématique d’un appareil de commutation électrique comportant un actionneur électromagnétique conforme à des modes de réalisation de l’invention ;

[Fig 2] la figure 2 une vue schématique d’un exemple du circuit de commande de l’actionneur électromagnétique de l’appareil de commutation de la figure 1 ;

[Fig 3] la figure 3 est un graphe représentant l’évolution d’un courant électrique de commande de l’actionneur électromagnétique de la figure 2 au cours de plusieurs phases de fonctionnement ;

[Fig 4] la figure 4 est un exemple d’impulsion de courant électrique utilisée pour estimer une ou plusieurs propriétés de l’actionneur électromagnétique de la figure 2 ;

[Fig 5] est un diagramme représentant des étapes d'un procédé d'évaluation de propriétés de l'appareil de commutation de la figure 1 conforme à des modes de réalisation de l'invention.

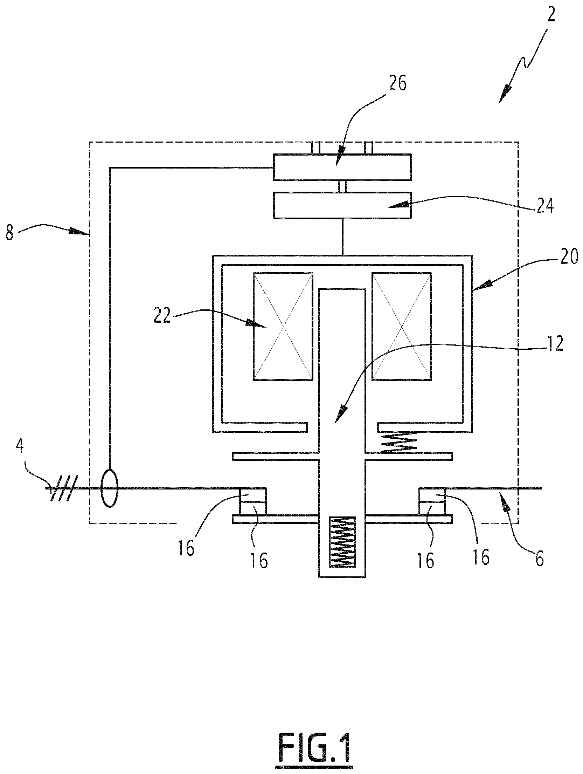

La figure 1 représente un appareil de commutation électrique 2, tel qu'un contacteur.

L'appareil 2 est configuré pour être commuté entre un état fermé dans lequel il laisse passer le courant électrique et un état ouvert dans lequel il empêche le passage d'un courant électrique.

Par exemple, l'appareil 2 peut être installé dans une installation électrique pour contrôler l'alimentation en électricité d'une charge électrique, telle qu'un moteur, par une source d'énergie électrique. La source d'énergie est, par exemple, un réseau d'alimentation électrique ou un générateur.

Dans l'exemple illustré, l'appareil 2 est relié, d'une part, à une ligne électrique amont 4 et, d'autre part, à une ligne électrique aval 6.

Les lignes électriques 4 et 6 peuvent comporter plusieurs phases électriques, par exemple pour acheminer un courant électrique alternatif triphasé. Quel que soit le nombre de phases, l'appareil 2 est configuré pour interrompre, ou alternativement autoriser la circulation, d'un courant électrique dans chacune des phases. Cependant, pour simplifier la figure 1, seul un conducteur électrique est illustré pour chacune des lignes électriques 4 et 6.

L'appareil 2 comporte par exemple un boîtier 8.

Pour chaque phase électrique, l'appareil 2 comprend des contacts séparables 10, disposés sur une partie mobile 12, et des contacts fixes 14, liés aux lignes électriques amont 4 et aval 6. Chacun des contacts 10 et 14 comprend des pastilles de contact 16, réalisées ici en métal, de préférence en alliage d'argent ou tout matériau équivalent.

La partie mobile 12 de l'appareil 2 est déplaçable entre une position fermée, dans laquelle les contacts mobiles 10 sont en contact avec les contacts fixes 14, et une position ouverte, représentée sur la figure 1, dans laquelle les contacts mobiles 10 sont éloignés des contacts fixes 14.

En pratique, au cours de chaque cycle comprenant une phase de fermeture et d'ouverture, les pastilles de contact 16 s'usent, par exemple sous l'action d'arcs électriques au cours de l'ouverture, ou encore par arrachement de matière causé par des microsoudures. Cette perte de matière a pour conséquence que l'épaisseur des pastilles de contact 16 se réduit tout au long de la vie de l'appareil 2, ce qui augmente l'amplitude du mouvement de la partie mobile lors des phases d'ouverture ou de fermeture.

Pour y remédier, l'appareil 2 peut comporter un mécanisme, représenté schématiquement par un ressort sur la figure 1, qui est lié à un barreau de la partie mobile et qui permet de maintenir les contacts fixes et mobiles en contact électrique avec une pression de contact suffisante.

Le mécanisme peut être réglé pour écraser les contacts en position fermée, afin de produire une pression de contact suffisante. Pour cela, on peut prévoir une surcourse du mécanisme, c'est-à-dire qu'en position fermée, les contacts sont poussés à une position allant au-delà de la position strictement nécessaire pour obtenir un contact électrique entre les contacts fixe et mobile.

Lorsque l'épaisseur des pastilles de contact 16 est insuffisante ou que l'état de surface des pastilles 16 est mauvais, les risques de dysfonctionnement de l'appareil 2 augmentent. Il convient alors de remplacer l'appareil 2. C'est pour ces raisons qu'un diagnostic de l'état d'écrasement des contacts permet d'évaluer l'avancement de la dégradation de l'appareil 2.

L'appareil 2 comporte également un actionneur électromagnétique 20 configuré pour déplacer la partie mobile 12 entre la position de fermeture et la position d'ouverture.

L'actionneur 20 électromagnétique comporte une bobine 22 configurée pour générer un champ magnétique lorsqu'elle est alimentée par un courant électrique de commande, afin de mettre en mouvement la partie mobile 12.

Par exemple, la bobine 22 comporte un enroulement d'un fil électriquement conducteur. La partie mobile 12 peut être montée solidairement d'un noyau magnétique agencé coaxialement avec la bobine 22 et qui se déplace sous l'effet du champ magnétique généré par la bobine 22 lorsque celle-ci est excitée par injection d'un courant électrique approprié.

L'appareil 2 comporte en outre un circuit d'alimentation 24, configuré pour alimenter électriquement la bobine 12, et un dispositif électronique de commande 26 configuré pour piloter le circuit d'alimentation 24.

Dans de nombreux modes de réalisation, l'appareil 2 comprend une interface d'entrée qui est configurée pour recevoir des ordres d'ouverture ou de fermeture en provenance d'un utilisateur. Par exemple, une tension électrique de commande peut être appliquée entre des bornes de l'interface d'entrée.

Dans de nombreux modes de réalisation, l'appareil 2 comprend aussi un capteur de courant 28 configuré pour mesurer un courant circulant dans chacune des phases de la ligne amont 4. Dans d'autres modes de réalisation, les capteurs de courant et le dispositif électronique de commande sont intégrés dans un boîtier distinct de l'appareil 2.

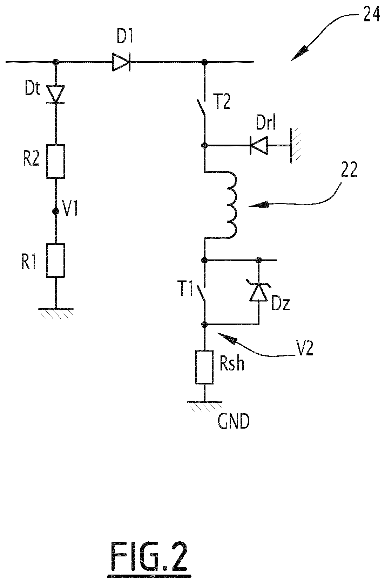

La figure 2 représente un mode de réalisation du circuit d'alimentation 24.

Dans l'exemple illustré, le circuit d'alimentation 24 comporte un rail d'alimentation électrique Vc adapté pour être alimenté électriquement soit par une alimentation extérieure, soit par le signal de commande reçu par l'appareil 2.

De préférence, le circuit d'alimentation 24 comprend un dispositif de mesure configuré pour mesurer la valeur de la tension électrique entre le rail d'alimentation Vc et une masse électrique GND du circuit 24.

Par exemple, le dispositif de mesure comprend deux résistances R1 et R2 connectées en série avec une diode Dt entre le rail d'alimentation Vc et la masse électrique GND. Un premier point de mesure, ici placé entre les résistances R1 et R2, permet de collecter une première tension de mesure V1 représentative de la tension électrique présente entre le rail d'alimentation Vc et la masse électrique GND.

Le circuit d'alimentation 24 comporte également un ou plusieurs interrupteurs de puissance connectés à la bobine 22 pour sélectivement connecter ou déconnecter la bobine 22 du rail d'alimentation Vc et de la masse GND.

Par exemple, un premier interrupteur T1 est connecté entre la bobine 22 et la masse GND. Un deuxième interrupteur T2 est connecté entre la bobine 22 et le rail d'alimentation Vc.

Par exemple, lorsque les deux interrupteurs T1 et T2 sont fermés, une tension électrique dépendant de la tension Vc est appliquée aux bornes de la bobine 22 et un courant électrique d'excitation circule dans la bobine 22. Lorsque seul le deuxième interrupteur T2 est ouvert, la bobine 22 peut se décharger et un courant électrique résiduel peut continuer à circuler temporairement dans la bobine 22.

Les interrupteurs T1 et T2 sont par exemple pilotés par le dispositif électronique de commande 26. Selon des exemples de mise en œuvre, les interrupteurs T1 et T2 sont des interrupteurs de puissance à semi-conducteurs, tels que des transistors Mosfet, ou des thyristors, ou des transistors bipolaires à grille isolée (IGBT), ou tout autre dispositif équivalent.

Dans l'exemple illustré, une diode Drl dite de roue libre est connectée entre le deuxième interrupteur T2 et la masse GND. Une diode Zéner Dz peut être connectée en parallèle du premier interrupteur T1. Une diode D1 peut être placée sur le rail d'alimentation Vc entre le deuxième interrupteur T2 et le dispositif de mesure pour éviter tout retour de courant vers ce dernier.

Dans de nombreux modes de réalisation, une résistance Rsh est connectée en série avec le premier interrupteur T1 pour collecter une deuxième tension de mesure V2 représentative du courant électrique qui circule dans la bobine 22.

L'architecture du circuit d'alimentation 24 n'est pas limitative et d'autres implémentations sont possibles.

De façon générale, le dispositif électronique de commande 26 est configuré pour assurer la commutation de l'appareil 2 lorsqu'il reçoit un ordre de commande approprié.

Avantageusement, le dispositif électronique de commande 26 est également configuré pour estimer au moins une propriété de l'appareil 2 pendant le fonctionnement de l'appareil 2, et notamment une ou plusieurs propriétés de la bobine 22, telles que la résistance de la bobine 22, l'inductance de la bobine 22 et la température de la bobine 22, comme cela sera mieux compris à la lecture de ce qui va suivre.

Dans de nombreux modes de réalisation, le dispositif électronique de commande 26 est implémenté par un ou plusieurs circuits électroniques.

Par exemple, le dispositif électronique de commande 26 comporte un processeur, tel qu'un microcontrôleur programmable ou un microprocesseur, et une mémoire informatique, ou tout support d'enregistrement de données lisible par ordinateur.

Selon des exemples, la mémoire est une mémoire ROM, ou une mémoire RAM, ou une mémoire non volatile du type EPROM ou Flash ou équivalent. La mémoire comporte des instructions exécutables et/ou du code informatique pour assurer le fonctionnement du dispositif de commande 26 conformément à un ou plusieurs des modes de réalisation décrits ci-après lorsqu'exécuté par le processeur.

Selon des variantes, le dispositif électronique de commande 26 peut comporter un processeur de traitement du signal (DSP), ou un composant logique reprogrammable (FPGA), ou un circuit intégré spécialisé (ASIC), ou tout élément équivalent.

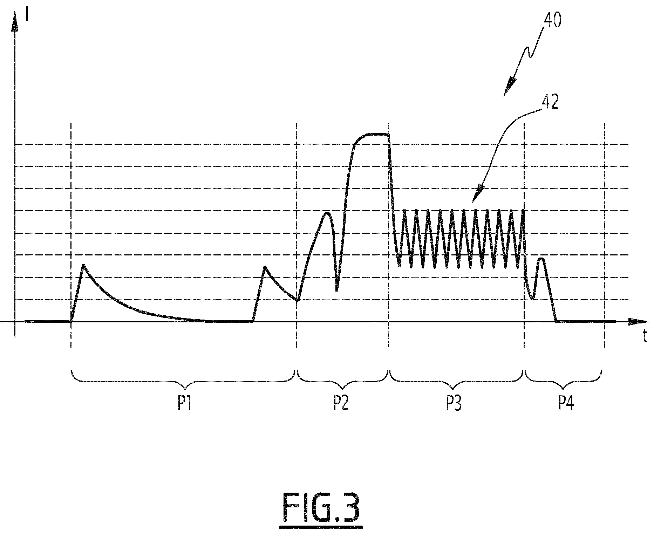

La figure 3 représente un graphique 40 illustrant l'évolution du courant électrique (I) circulant dans la bobine 22 au cours du temps (t) lors de différentes phases de fonctionnement successives de l'appareil 2, notées P1, P2, P3 et P4, dans le cas où l'appareil 2 est commuté vers l'état fermé, puis à nouveau commuté vers l'état ouvert. Ce courant électrique est nommé « courant bobine » dans ce qui suit.

La première phase P1 est une phase initiale, pendant laquelle l'appareil 2 est à l'état ouvert de façon stable. En pratique, le deuxième interrupteur T2 reste ouvert et le courant bobine reste nul.

Optionnellement, comme visible sur la figure, des impulsions de courant peuvent être injectées dans la bobine 22 à des fins d'estimation desdites propriétés.

La deuxième phase P2 correspond à une phase de fermeture, après qu'un ordre de fermeture ait été reçu par l'appareil 2. Par exemple, les interrupteurs T1 et T2 sont fermés. Le courant bobine augmente jusqu'à atteindre un seuil à partir duquel la partie mobile 12 commence à se déplacer de sa position ouverte vers sa position fermée. Dans la suite de la phase de fermeture, le courant bobine augmente jusqu'à une valeur plateau alors que les contacts mobiles 14 arrivent en appui sur les contacts fixes 10. L'appareil 2 est alors dans l'état fermé.

Lors d'une troisième phase P3, dite phase de maintien, le courant bobine reste maintenu au-dessus de la valeur de seuil. En pratique, le courant bobine peut, pendant cette phase de maintien, rester inférieur à la valeur plateau atteinte lors de la phase de fermeture.

Optionnellement, comme visible sur la figure, la tension bobine peut-être variée de manière périodique, de manière à réduire le plus possible l'intensité du courant bobine tout en le maintenant au-dessus dudit seuil, ceci afin d'éviter des déperditions d'énergie inutiles.

Dans l'exemple illustré, la variation périodique de la tension bobine est obtenue en ouvrant et fermant alternativement le deuxième interrupteur T2 avec une fréquence de hachage prédéfinie, ce qui crée des oscillations de la tension bobine suivant un profil prédéfini. En conséquence, le courant bobine présente également des oscillations 42 entre deux valeurs d'intensité. Pendant ce temps, le premier interrupteur T1 peut rester fermé.

Pour éviter que des vibrations mécaniques résultant de ces oscillations ne génèrent un bruit perceptible par l'oreille humaine, la fréquence de hachage est avantageusement choisie inférieure à 100 Hz, ou supérieure à 25 kHz. Dans l'exemple illustré, la fréquence de hachage est de 100 Hz.

La phase d'ouverture P4 commence lorsque le dispositif électronique de contrôle 26 reçoit un ordre d'ouverture. Les interrupteurs T1 et T2 sont tous deux ouverts.

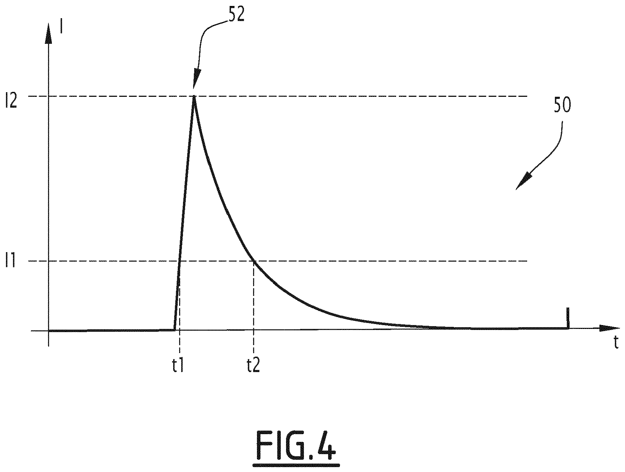

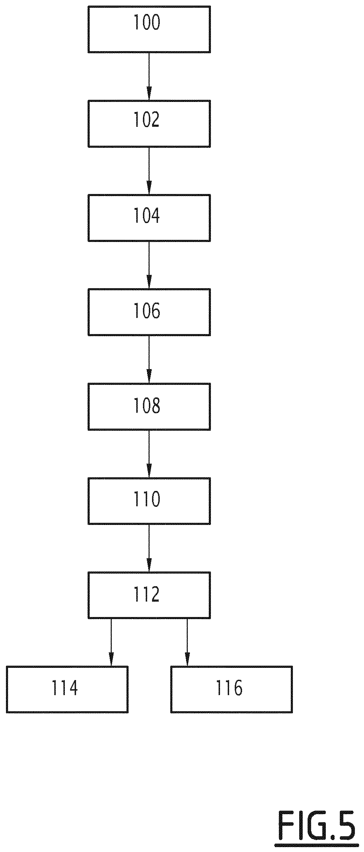

Un exemple de fonctionnement d'un procédé d'estimation de propriétés de l'appareil 2 est maintenant décrit en référence aux figures 4 et 5.

Comme illustré par le diagramme de la figure 5, le procédé est d'abord initialisé par une étape 100.

Ensuite, le circuit de commande 26 commence à mesurer le courant électrique circulant dans la bobine (étape 102) et la tension électrique d'alimentation Vc qui est imposée par le circuit d'alimentation 24 (étape 104).

Par exemple, ces mesures sont répétées au cours du temps, par échantillonnages successifs. Dans l'exemple illustré sur la figure 2, ces mesures consistent à mesurer les valeurs des première et deuxième tensions V1 et V2. Les valeurs mesurées peuvent être enregistrées dans une mémoire du dispositif de commande 26.

Ensuite, à l'étape 106, une impulsion de courant électrique est injectée dans la bobine 22 de l'actionneur 20 au moyen du circuit d'alimentation 24, par exemple en faisant varier la tension appliquée aux bornes de la bobine 22. Pour ce faire, les interrupteurs T1 et T2 peuvent être fermés brièvement.

Comme illustré par l'exemple de la figure 4, qui représente l'évolution du courant bobine (I) en fonction du temps (t), l'impulsion de courant 40 peut présenter un front montant qui augmente jusqu'à une valeur maximale I2, par exemple avec une loi d'évolution exponentielle.

L'atteinte de cette valeur maximale correspond ici à un pic 52 de l'impulsion 50.

Ce front montant est suivi par un front descendant, qui diminue depuis la valeur maximale I2 jusqu'à une valeur finale, telle que la valeur d'origine ou une valeur nulle, ici en décroissant selon une loi exponentielle. Ainsi, l'impulsion de courant présente ici une forme dite en aileron de requin.

On définit une valeur seuil prédéterminée, ici notée I1, comprise entre la valeur minimale et la valeur maximale I2 du courant bobine. Lorsque l'impulsion de courant 50 est injectée, le courant bobine passe une première fois par cette valeur seuil prédéterminée I1 pendant le front montant, puis passe une deuxième fois par cette valeur seuil prédéterminée I1 pendant le front descendant.

Ainsi, lors d'une étape 108 postérieure à l'étape 106, le dispositif de commande 26 identifie un premier instant (t1) correspondant à l'instant pour lequel le courant circulant dans la bobine atteint la valeur seuil prédéterminée I1 lorsque ledit courant augmente suite à l'injection de l'impulsion.

La valeur seuil prédéterminée I1 peut être fixée à l'avance, par exemple enregistrée en mémoire. Par exemple, la valeur seuil est choisie suffisamment basse pour conserver assez de signal et réaliser la mesure. A titre d'exemple, la valeur seuil pourrait être égale à 10% de la valeur maximale I2.

Ensuite, lors d'une étape 110, le dispositif de commande 26 identifie un deuxième instant (t2) correspondant à l'instant pour lequel le courant circulant dans la bobine atteint à nouveau la valeur seuil prédéterminée I1 lorsque ledit courant diminue après le pic de l'impulsion.

Par exemple, l'identification des premier et deuxièmes instants est basée sur les mesures de courant bobine initiées à l'étape 102 et qui continuent à se poursuivre.

Lors d'une étape 112, la résistance de la bobine est estimée à partir du rapport entre la somme des valeurs de ladite tension mesurées entre le deuxième instant t2 et le premier instant t1, et la somme des valeurs dudit courant mesurées entre le deuxième instant t2 et le premier instant t1.

Selon un exemple de mise en œuvre, dès que le passage de la valeur seuil I1 est détecté à l'instant t1, le dispositif de commande 26 déclenche une sommation des valeurs de tension jusqu'à ce que le passage de la valeur seuil I1 par courant bobine à l'instant t2 soit détecté et enregistre la somme correspondante $\Sigma U$ en mémoire. Le dispositif de commande 26 procède de même pour les valeurs de courant bobine mesurées et enregistre la somme correspondante $\Sigma I$ en mémoire.

La valeur de résistance, notée R, est ensuite estimée comme étant le rapport de ces deux sommes, comme illustré par la formule suivante :

$$R = \frac{\sum_{t1}^{t2} U}{\sum_{t1}^{t2} I}$$

En d'autres termes, on peut déclencher l'addition des échantillons de courant et de tension bobine à partir du seuil en courant I1 et on arrête cette addition lorsque le courant bobine atteint de nouveau ce seuil.

Le procédé d'estimation de la résistance peut est mis en œuvre lorsque l'appareil 2 est dans l'état ouvert, de préférence pendant la phase P1 décrite ci-dessus. Dans ce cas, de façon optionnelle mais néanmoins avantageuse, le procédé d'estimation peut être mis en œuvre dès la mise sous tension de l'appareil 2, afin de s'assurer que les conditions de fonctionnement de l'appareil sont conformes aux exigences de sécurité, avant de pouvoir déclencher la phase de fermeture.

Le procédé d'estimation de la résistance peut aussi être mis en œuvre lorsque l'appareil 2 est dans l'état fermé, notamment pendant la phase de maintien P3 décrite ci-dessus. Dans ce cas, l'impulsion de courant peut être l'une des oscillations périodiques 42 du courant résultant du hachage de la tension bobine mis en œuvre par le circuit d'alimentation 24.

On dispose ainsi d'une façon fiable et relativement simple d'estimer la résistance, quelque soit l'état de l'appareil 2.

En variante, ce calcul peut être simplifié en estimant la résistance R au moyen de la formule suivante :

$$R = \frac{(R2\ + R1)/R1.\sum_{t}^{t+Ton} trs + \frac{Toff}{Ton + Toff}.Drl - RT4.\sum_{t}^{t+Ton} Icoil}{\sum_{t}^{t+Ton+Toff} Icoil} - (Rsh + RT1)$$

dans laquelle la somme $\sum_{t}^{t+Ton+Toff} Icoil$ correspond à la somme des courants bobine mesurés entre les instants t1 et t2, « trs » correspond à la tension bobine mesurée (première tension de mesure V1), « t » correspond à l'instant t1 précédemment défini, Ton correspond à la durée de l'impulsion de courant entre le premier instant t1 et le pic de courant 52 (la valeur maximale), les constantes R1, R2, Rsh sont les valeurs des résistances éponymes précédemment définies du circuit d'alimentation 24, Drl est la tension de la diode Drl à l'état passant, RT1 est l'impédance du premier interrupteur T1, RT4 est l'impédance du deuxième interrupteur et Toff correspond à la durée restante du front descendant de l'impulsion après le pic de courant 52 et jusqu'au deuxième instant t2.

Les valeurs de R1 et R2 peuvent être considérées comme des constantes de construction propres à l'appareil 2 et enregistrées en mémoire, par exemple lors de la construction de l'appareil 2. Les constantes Drl, RT4, Rsh, RT1 sont des constantes propres à l'appareil 2, qui peuvent aussi être enregistrées en mémoire, mais dont la valeur peut dépendre de la température.

En pratique, des valeurs connues de ces constantes peuvent être au préalable enregistrées en mémoire et sont ensuite chargées lors du démarrage de l'appareil 2, puis peuvent être mises à jour au cours du fonctionnement de l'appareil, par exemple lors d'opérations de correction, en fonction des valeurs de température estimées à l'aide de l'étape 114 décrite ci-après, et de lois donnant l'évolution de chacune constante en fonction de la température.

Optionnellement, l'identification des délais t1 et t2 comporte une sous-étape de correction visant à améliorer la précision de la détection.

En effet, selon les méthodes utilisées pour détecter que la valeur seuil I1 est franchie, il peut arriver que ce franchissement soit détecté avec un retard, introduisant ainsi une erreur sur l'estimation de la résistance.

Notamment, lors de l'étape 110, pour minimiser l'erreur de mesure lors de la phase de descente, au lieu de s'arrêter à la première mesure de courant dont la valeur est inférieure à la valeur seuil I1, on considère plutôt l'instant t2 comme étant l'instant pour lequel on mesure une valeur de courant la plus proche de la valeur seuil I1, même si cette valeur mesurée est supérieure à la valeur seuil I1.

En d'autres termes, lorsque cette correction est mise en œuvre, le deuxième instant t2 est identifié, comme étant l'instant pour lequel la valeur du courant mesuré est la plus proche de la valeur seuil I1 parmi les valeurs de courant mesurées lorsque ledit courant diminue après le pic de l'impulsion.

On comprend notamment que le procédé permet en premier lieu d'estimer la résistance de la bobine 22. Avantageusement, d'autres propriétés de la bobine 22, telles que la température et l'inductance, peuvent être estimées lors d'étapes ultérieures, en se basant sur la valeur de résistance estimée.

Par exemple, lors d'une étape 114, le dispositif de commande 26 estime la température de la bobine 22 à partir de la valeur de résistance R bobine estimée.

Selon un exemple de mise en œuvre, l'estimation de la température de la bobine peut être réalisé de façon itérative au cours du temps à partir d'une valeur précédente de température.

Cette estimation peut être réalisée au moyen de la formule suivante :

$$Temp_2 = \frac{\frac{Rbob_1}{Rbob_2} - 1}{K} + Temp_1$$

dans laquelle Temp2 est la nouvelle estimation de température, Temp1 est la précédente estimation de la température, Rbob2 est la valeur courante de la résistance de la bobine 22, Rbob1 est une valeur précédente de résistance de la bobine 22 et K est le coefficient thermique du matériau formant la bobine (par exemple du cuivre). Les valeurs de résistance de la bobine sont par exemple estimées au moyen du procédé précédemment décrit.

L'étape 114 peut être répétée plusieurs fois au cours du temps, par exemple de façon périodique. Lors de la première itération de l'étape 114, on peut utiliser comme valeurs initiales Rbob1 et Temp1 des valeurs initiales mesurées ou estimées lors de la première mise sous tension de l'appareil 2 puis enregistrées en mémoire du dispositif de commande 26.

Dans d'autres modes de réalisation, lors d'une étape 116, le dispositif de commande 26 estime l'inductance de la bobine 22 à partir de la valeur de résistance estimée.

Par exemple, l'inductance de la bobine, notée L, peut être estimée à partir de la formule suivante :

$$L = \frac{Drl.Toff - (Rsh + RT1 + Rbob).\sum_{t+Ton}^{t+Ton+Toff} Icoil}{\left(Icoil_{Ton} - Icoil_{Toff}\right)}$$

dans laquelle les grandeurs indiquées sont celles définies précédemment. Les grandeurs $Icoil_{Ton}$ et $Icoil_{Toff}$ correspondent respectivement aux valeurs de courant mesurées pour le pic de courant 52 et pour la fin de l'impulsion de courant t2.

De cette manière, l'inductance peut être estimée simplement, en tenant compte de toutes les chutes de tension. Le résultat est plus précis, car prenant en compte l'ensemble des paramètres qui peuvent créer de l'imprécision plus ou moins importante, tels que des tensions résiduelles et des résistances parasites. De plus, le calcul est facile à implémenter, c'est-à-dire qu'il ne nécessite que peu de ressources de calcul.

Ces exemples ne sont pas limitatifs et les étapes 114 ou 116 pourraient être mises en œuvre différemment.

En variante, les étapes du procédé pourraient être exécutées dans un ordre différent. Certaines étapes pourraient être omises. L'exemple décrit ne fait pas obstacle à ce que, dans d'autres modes de réalisation, d'autres étapes soient mises en œuvre conjointement et/ou séquentiellement avec les étapes décrites.

Grâce à l'invention, il est possible de déterminer automatiquement et de façon fiable la valeur de la résistance de la bobine de l'actionneur pendant le fonctionnement de l'appareil, sans avoir besoin de capteur dédié. D'autres propriétés, telles que la température et l'inductance, peuvent être ensuite estimées à partir de l'estimation de la résistance. On dispose ainsi d'une méthode simple à mettre en œuvre pour disposer de valeurs fiables sur l'état de la bobine 22, sans avoir besoin d'ajouter des capteurs supplémentaires (tels qu'un capteur de température proche de la bobine 22).

Optionnellement, l'état de l'appareil 2 (état ouvert ou fermé) peut être déterminé à partir d'une ou de plusieurs des propriétés estimées grâce au procédé ci-dessus.

Par exemple, un procédé de détermination de l'état de l'appareil 2 peut comporter une étape, non illustrée, de comparaison d'une ou de plusieurs de ces propriétés estimées par rapport à une ou plusieurs valeurs de référence. L'état de l'appareil 2 est déterminé en fonction du résultat de cette comparaison.

Toute caractéristique de l'un des modes de réalisation ou variante décrite ci-dessus, peut être mise en œuvre dans les autres modes de réalisation et variantes décrits.

## Revendications

1. Procédé pour estimer une propriété d'un appareil de commutation électrique (2), ledit appareil comportant un actionneur électromagnétique (20) comprenant une bobine (22), ce procédé comportant des étapes consistant à :

   - mesurer (102) le courant électrique circulant dans la bobine ;
   - mesurer (104) la tension électrique d'alimentation d'un circuit de commande de l'actionneur ;
   - injecter (106) une impulsion de courant électrique dans la bobine (22) de l'actionneur (20) ;

- identifier (108) un premier instant (t1) correspondant à l'instant pour lequel le courant circulant dans la bobine atteint une valeur seuil prédéterminée (I1) lorsque ledit courant augmente suite à l'injection de l'impulsion ;
- identifier (110) un deuxième instant (t2) correspondant à l'instant pour lequel le courant circulant dans la bobine atteint à nouveau la valeur seuil prédéterminée (I1) lorsque ledit courant diminue après le pic de l'impulsion ;
- estimer (112) la résistance de la bobine à partir du rapport entre la somme des valeurs de ladite tension mesurées entre le deuxième instant et le premier instant, et la somme des valeurs dudit courant mesurées entre le deuxième instant et le premier instant.

**2.** Procédé selon la revendication 1, dans lequel le procédé comporte en outre une étape d'estimation (116) de l'inductance de la bobine (22) de l'actionneur en fonction de la valeur de résistance estimée.

**3.** Procédé selon la revendication 2, dans lequel l'inductance (L) est calculée au moyen de la formule suivante :

$$L = \frac{Drl.Toff - (Rsh + RT1 + Rbob).\sum_{t+Ton}^{t+Ton+Toff} Icoil}{\left(Icoil_{Ton} - Icoil_{Toff}\right)}$$

dans laquelle Rbob est la valeur de résistance estimée, $Icoil_{Ton}$ et $Icoil_{Toff}$ correspondent respectivement aux valeurs de courant mesurées au maximum de l'impulsion (52) et à la fin de l'impulsion de courant (t2), Toff correspond à la durée restante de l'impulsion de courant après l'atteinte du maximum de l'impulsion (52), Drl, Rsh et RT1 sont des constantes de construction propres à l'appareil (2) et enregistrées en mémoire.

**4.** Procédé selon l'une quelconque des revendications précédentes, dans lequel le procédé comporte en outre une étape d'estimation (114) de la température de la bobine de l'actionneur en fonction de la valeur de résistance estimée.

**5.** Procédé selon la revendication 4, dans lequel la température de la bobine est calculée de façon itérative au moyen de la formule suivante :

$$Temp_2 = \frac{\frac{Rbob_1}{Rbob_2} - 1}{K} + Temp_1$$

dans laquelle Temp2 est la valeur courante de la température de la bobine, Temp1 est la précédente estimation de la température, Rbob2 est la valeur courante de la résistance de la bobine, Rbob1 est une valeur précédente de la résistance de la bobine et K est le coefficient thermique du matériau formant la bobine.

**6.** Procédé selon l'une quelconque des revendications précédentes, dans lequel la résistance de la bobine est estimée au moyen de la formule suivante :

$$R = \frac{(R2\ + R1)/R1.\sum_{t}^{t+Ton} trs + \frac{Toff}{Ton + Toff}.Drl - RT4.\sum_{t}^{t+Ton} Icoil}{\sum_{t}^{t+Ton+Toff} Icoil} - (Rsh + RT1)$$

dans laquelle la somme $\sum_{t}^{t+Ton+Toff} Icoil$ correspond à la somme des valeurs de courant mesurés entre les premier et deuxième instants (t1, t2), « trs » correspond à la tension bobine mesurée, « t » correspond au premier instant (t1) précédemment défini, Ton correspond à la durée de l'impulsion de courant entre le premier instant t1 et l'atteinte d'une valeur maximale (52) de l'impulsion de courant, Toff correspond à la durée restante de l'impulsion de courant après l'atteinte du maximum de courant (52) et jusqu'au deuxième instant (t2), Drl, Rsh, R1, R2, RT4 et RT1 sont des constantes de construction propres à l'appareil (2) et enregistrées en mémoire.

**7.** Procédé selon l'une quelconque des revendications précédentes, dans lequel le procédé est mis en œuvre lorsque l'appareil de commutation (2) est dans l'état ouvert.

**8.** Procédé selon l'une quelconque des revendications 1 à 6, dans lequel le procédé est mis en œuvre lorsque l'appareil de commutation (2) est dans l'état fermé, de préférence pendant une phase de maintien dans laquelle l'impulsion de courant est répétée périodiquement.

**9.** Procédé selon l'une quelconque des revendications précédentes, dans lequel le deuxième instant (t2) est identifié comme étant l'instant pour lequel la valeur du courant mesuré est la plus proche de la valeur seuil prédéterminée (I1) parmi les valeurs de courant mesurées lorsque ledit courant diminue après le pic de l'impulsion.

**10.** Appareil de commutation électrique, comportant un actionneur électromagnétique comprenant une bobine et un circuit de commande configuré pour mettre en œuvre des étapes consistant à :

- mesurer (102) le courant électrique circulant dans la bobine ;
- mesurer (104) la tension électrique d'alimentation d'un circuit de commande de l'actionneur ;
- injecter (106) une impulsion de courant électrique dans la bobine (22) de l'actionneur (20) ;
- identifier (108) un premier instant (t1) correspondant à l'instant pour lequel le courant circulant dans la bobine atteint une valeur seuil prédéterminée (I1) lorsque ledit courant augmente suite à l'injection de l'impulsion ;
- identifier (110) un deuxième instant (t2) correspondant à l'instant pour lequel le courant circulant dans la bobine atteint à nouveau la valeur seuil prédéterminée (I1) lorsque ledit courant diminue après le pic de l'impulsion ;
- estimer (112) la résistance de la bobine à partir du rapport entre la somme des valeurs de ladite tension mesurées entre le deuxième instant et le premier instant, et la somme des valeurs dudit courant mesurées entre le deuxième instant et le premier instant.

2
26
24
8
20
22
12
4
16
16
16
16
6

FIG.1

24
D1
Dt
T2
Drl
R2
22
V1
R1
T1
Dz
V2
Rsh
GND

FIG.2

I
40
42
t
P1
P2
P3
P4

FIG.3

52
I
I2
50
I1
t1
t2
t

FIG.4

100
102
104
106
108
110
112
114
116

FIG.5

Europäisches
Patentamt
European
Patent Office
Office européen
des brevets

# RAPPORT DE RECHERCHE EUROPEENNE

Numéro de la demande
EP 21 18 6426

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2018/174786 A1 (MATSUO NAOYUKI [JP] ET AL) 21 juin 2018 (2018-06-21) | 1-3,5-10 | INV. H01H47/00 H01H47/32 |
| Y | * alinéas [0047] - [0088]; figures * | 4 | |
| Y | EP 2 998 977 A1 (ABB TECHNOLOGY AG [CH]) 23 mars 2016 (2016-03-23) | 4 | |
| A | * alinéa [0049]; figures * | 1,10 | |
| A | US 2019/057827 A1 (KHAN ZAFARULLAH [US]) 21 février 2019 (2019-02-21) * alinéas [0020] - [0046]; figures * | 1,10 | |

DOMAINES TECHNIQUES RECHERCHES (IPC)

H01H

1 Le présent rapport a été établi pour toutes les revendications

| Lieu de la recherche | Date d'achèvement de la recherche | Examinateur |
|---|---|---|
| Munich | 21 décembre 2021 | Findeli, Luc |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE RELATIF A LA DEMANDE DE BREVET EUROPEEN NO.

EP 21 18 6426

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

21-12-2021

| Document brevet cité au rapport de recherche | Date de publication | Membre(s) de la famille de brevet(s) | Date de publication |
|---|---|---|---|
| US 2018174786 A1 | 21-06-2018 | CN 107924787 A | 17-04-2018 |
| | | EP 3432335 A1 | 23-01-2019 |
| | | JP 6504312 B2 | 24-04-2019 |
| | | JP WO2017159070 A1 | 26-07-2018 |
| | | US 2018174786 A1 | 21-06-2018 |
| | | WO 2017159070 A1 | 21-09-2017 |
| EP 2998977 A1 | 23-03-2016 | AU 2015317193 A1 | 16-03-2017 |
| | | CN 107112166 A | 29-08-2017 |
| | | EP 2998977 A1 | 23-03-2016 |
| | | US 2017250042 A1 | 31-08-2017 |
| | | WO 2016041691 A1 | 24-03-2016 |
| US 2019057827 A1 | 21-02-2019 | CA 3072812 A1 | 21-02-2019 |
| | | US 2019057827 A1 | 21-02-2019 |
| | | WO 2019036644 A2 | 21-02-2019 |

EPO FORM P0460

Pour tout renseignement concernant cette annexe : voir Journal Officiel de l'Office européen des brevets, No.12/82